# FASCICULE DE BREVET EUROPEEN

(11) **EP 2 825 499 B1**
(45) Date de publication et mention de la délivrance du brevet: **24.04.2019**
(21) Numéro de dépôt: 13715297.1
(22) Date de dépôt: 11.03.2013
(51) Int. Cl.: B81C 1/00

(54) **TRAITEMENT DE SURFACE DE DISPOSITIFS MICROFLUIDIQUES**
OBERFLÄCHENBEHANDLUNG VON MIKROFLUIDISCHEN VORRICHTUNGEN
SURFACE TREATMENT OF MICROFLUIDIC DEVICES

(30) Priorité: 13.03.2012 FR 1252245
(43) Date de publication de la demande: 21.01.2015
(73) Titulaire: Total Petrochemicals France, 92400 Courbevoie (FR); Ecole Supérieure de Physique et Chimie Industrielles de la Ville de Paris, 75005 Paris (FR); Centre National de la Recherche Scientifique (C.N.R.S.), 75016 Paris (FR)
(72) Inventeur: AZIOUNE, Ammar, 33700 Merignac (FR); BARTOLO, Denis, 69002 Lyon (FR); LEVACHE, Bertrand, 64000 Pau (FR); STUDER, Vincent, 33000 Bordeaux (FR)
(74) Mandataire: Cabinet Plasseraud
(86) Numéro de dépôt international: PCT/FR2013/050508
(87) Numéro de publication internationale: WO 2013/136003

(56) Documents cités:
- JP-A- 2008 058 132
- BERDICHEVSKY Y ET AL: "UV/ozone modification of poly(dimethylsiloxane) microfluidic channels", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER S.A, SWITZERLAND, vol. 97, no. 2-3, 1 février 2004 (2004-02-01), pages 402-408, XP004486646, ISSN: 0925-4005, DOI: 10.1016/J.SNB.2003.09.022
- CHIA-JUNG CHANG ET AL: "Fabrication of a SU-8-based polymer-enclosed channel with a penetrating UV/ozone-modified interior surface for electrokinetic separation of proteins;Fabrication of a SU-8-based polymer-enclosed channel", JOURNAL OF MICROMECHANICS & MICROENGINEERING, INSTITUTE OF PHYSICS PUBLISHING, BRISTOL, GB, vol. 20, no. 11, 21 octobre 2010 (2010-10-21), page 115031, XP020200035, ISSN: 0960-1317, DOI: 10.1088/0960-1317/20/11/115031

## Description

### DOMAINE TECHNIQUE DE L'INVENTION

L'invention a pour objet un procédé de traitement de surface des parois internes d'un microcanal, dans un dispositif microfluidique, ainsi qu'un procédé de fabrication d'un dispositif microfluidique comprenant une telle étape de traitement de surface.

### ART ANTERIEUR

La microfluidique désigne une branche des sciences qui étudie et tente d'exploiter les mécanismes de l'écoulement des fluides, liquides ou gaz, à travers des canaux aux dimensions allant du millimètre au nanomètre. Cette discipline connaît un essor remarquable depuis les vingt dernières années, et est utilisée dans de nombreux domaines, tels que la chimie, les biotechnologies, la biologie et la mécanique des fluides.

De nombreuses méthodes de fabrication de dispositifs microfluidiques ont été décrites dans la littérature. La méthode qui cependant s'est imposée consiste à fabriquer les dispositifs microfluidiques en des matériaux polymères de type thermo- ou photo-durcis par réplication à l'aide d'un moule. Cette méthode présente l'avantage d'être simple, efficace, rapide et peu coûteuse. Un des matériaux polymères thermo-durcis les plus utilisés est le PDMS (polydiméthylsiloxane).

Un des problèmes liés toutefois à l'utilisation de ces matériaux réside dans le fait qu'ils sont naturellement peu hydrophiles, voire même hydrophobes. Les microcanaux dans les dispositifs microfluidiques obtenus sont donc peu ou pas hydrophiles. Or, pour de nombreuses applications, il serait intéressant de disposer de dispositifs microfluidiques avec des microcanaux totalement ou partiellement hydrophiles. En outre, il serait utile de disposer d'un procédé permettant de contrôler et d'ajuster le caractère hydrophile ou hydrophobe des parois des microcanaux. Il serait également utile de disposer d'un procédé permettant de texturer les parois des microcanaux. Par « texturer », on entend modifier localement selon un motif désiré le caractère hydrophile ou hydrophobe des parois des microcanaux.

Des traitements de surface de dispositifs microfluidiques ont déjà été étudiés et décrits, principalement pour des applications dans le domaine de la biologie. L'article scientifique de Zhou et al intitulé « Recent developments in PDMS surface modification for microfluidic devices » (Electrophoresis 2010, 31, 2-16) présente, par exemple, une revue des différentes méthodes de traitement de surface du PDMS. On distingue généralement deux types de méthodes : les traitements physiques et les traitements chimiques. Les traitements chimiques, comme le dépôt de revêtement ou la fonctionnalisation par voie chimique de la surface, donnent de très bons résultats, mais présentent l'inconvénient majeur de ne pas permettre de traitement local précis. En outre, les traitements chimiques sont difficiles à mettre en place. Par ailleurs, les traitements chimiques connus ne permettent pas d'obtenir des surfaces très hydrophiles : l'angle de contact de l'eau dans l'air obtenu après traitement chimique est toujours supérieur à 50°. L'avantage des traitements physiques est qu'ils permettent, de manière simple, de traiter localement un dispositif.

Le traitement physique le plus commun est le traitement par plasma d'oxygène. Ce traitement est par exemple décrit dans l'article « Crosslinked polydimethylsiloxane exposed to oxygen plasma studied by neutron reflectometry and other surface specific techniques » de Hillborg et al (Polymer 41 (2000) 6851-6863). Le problème majeur de ce type de technique est que le matériau perd très rapidement son caractère hydrophile après traitement. Le caractère hydrophile ne peut être maintenu pendent une longue durée qu'au prix, soit de traitements complémentaires, soit d'un stockage dans des conditions particulières.

Une solution à ce problème a été proposée par Berdichevsky et al dans l'article « UV/ozone modification of poly(dimethylsiloxane) microfluidic channel » (Sensor and Actuators B 97 (2004) 402-408) . Il y est proposé de traiter les dispositifs en PDMS par plasma d'oxygène, puis par irradiation UV sous ozone. Ce dernier traitement, qui dure au minimum 30 minutes, permet d'oxyder en profondeur le PDMS et ainsi de maintenir le caractère hydrophile de la surface obtenu grâce au traitement par plasma d'oxygène. Cependant, la modification en profondeur du matériau a pour conséquence que le matériau perd ses propriétés mécaniques. Cette oxydation en profondeur va notamment avoir pour conséquence de rétrécir le matériau d'environ 30%. Néanmoins, ce traitement en profondeur est indispensable d'après les auteurs de cet article car c'est grâce à cette oxydation en profondeur du polymère que le caractère hydrophile/hydrophobe de la surface est modifié de façon durable dans le temps.

Une autre publication scientifique (CHANG et al. « Fabrication of a SU-8-based polymer-enclosed channel with a penetrating UV/ozone-modified interior surface for electrokinetic séparation of proteins », Journal of Micromechanics and Microengineering, 20 (2010) 115031) décrit un procédé pour rendre hydrophiles des surfaces naturellement hydrophobes d'un microcanal en SU-8 (un matériau à base époxy) de façon permanente et uniforme. Ce procédé consiste à irradier les parois du microcanal avec des UV de 254 nm dans un environnement riche en ozone après la fermeture du dispositif. Ce procédé nécessite donc l'utilisation d'ozone, ce qui représente une contrainte en termes d'équipement et de coût. De plus, les radiations UV ne peuvent pénétrer dans le microcanal qu'après avoir traversé la partie supérieure du dispositif microfluidique qui est en SU-8. Cet article précise que seuls 8% des irradiations traversent effectivement le matériau, ce qui implique que 92% des irradiations sont absorbées, provoquant vraisemblablement une modification en profondeur du matériau constituant la partie supérieure du dispositif.

Cet article suggère aussi une méthode alternative qui consiste à irradier le matériau à 172 nm dans l'atmosphère ambiante, l'ozone étant alors généré in situ. Cependant, ce mode de réalisation ne peut pas être mis en pratique selon le procédé décrit dans cet article dans la mesure où le matériau SU-8 n'est pas transparent aux UV ayant une longueur d'onde de 172 nm. L'irradiation du microcanal dans le dispositif microfluidique après sa fermeture, selon cette méthode alternative décrite dans cet article, n'est donc pas réalisable.

Enfin, la demande de brevet japonaise JP 2008 058132 décrit un procédé de traitement de surface d'un dispositif microfluidique en polydiméthysiloxane pour rendre celui-ci hydrophile sans former de craquelure. Dans ce procédé, une irradiation UV à 172 nm est appliquée sur le substrat en polydiméthylsiloxane dans lequel est tracé le microcanal et sur le couvercle avant la fermeture du dispositif. Un traitement de surface in situ du microcanal n'est pas possible. De plus, ce document japonais prévoit que l'irradiation soit faite de telle sorte que la partie du substrat formant le microcanal et la partie du substrat formant la surface adhésive qui est destinée à assurer la fermeture avec le couvercle reçoivent toutes les deux une irradiation UV d'énergie différente. Pour ce faire, soit deux irradiations successives doivent être faites avec des masquages différents, soit l'irradiation doit être faite avec un masquage particulier ayant une densité optique modulable. Ce procédé n'est donc pas facile à mettre en oeuvre car il nécessite soit plusieurs étapes d'irradiations successives qui s'accompagnent de délicates étapes d'alignements des masques, soit l'emploi de masquages spécifiques ayant une densité optique modulable.

La présente invention a, entre autres, pour objectif de fournir un procédé de traitement de surface de dispositifs microfluidiques dans des matériaux polymères de type thermo- ou photo-durcis, permettant de modifier de façon contrôlée et locale le caractère hydrophile ou hydrophobe des parois des microcanaux, ne présentant pas les inconvénients de l'art antérieur.

### RESUME DE L'INVENTION

C'est dans ce contexte que les inventeurs ont mis au point un procédé de traitement de surface destiné à traiter les parois internes d'un microcanal formé dans un matériau polymère au moins partiellement photo-durci ou thermo-durci. Ce traitement est fait par irradiation sous air à une longueur d'onde inférieure ou égale à 300 nm.

Plus précisément, la présent invention a pour objet un procédé de traitement de surface des parois internes d'un microcanal, dans un dispositif microfluidique, destiné à modifier au moins localement l'énergie de surface desdites parois, le microcanal étant délimité par un élément profilé en un matériau polymère au moins partiellement photo-durci ou thermo-durci et par un couvercle, comprenant une étape consistant à irradier sous air,
- soit ledit matériau polymère au moins partiellement photo-durci ou thermo-durci à travers le couvercle, le couvercle et l'élément profilé ayant été préalablement assemblés, le couvercle étant constitué d'un matériau transparent auxdites irradiations,
- soit directement ledit matériau polymère au moins partiellement photo-durci ou thermo-durci, les parties de l'élément profilé destinées à assurer la fermeture avec le couvercle ayant été préalablement protégées desdites irradiations de manière à ce que lesdites parties ne soient pas modifiées par irradiation avant la fermeture avec le couvercle,
l'irradiation étant faite à une longueur d'onde inférieure ou égale à 300 nm, et ledit procédé de traitement conservant intactes les propriétés de volume du matériau, la profondeur de traitement étant inférieure ou égale à 100 nm ou étant inférieure à 1% de l'épaisseur totale du dispositif microfluidique.

L'invention a en outre pour objet un procédé de fabrication d'un dispositif microfluidique, comprenant :
- une étape de préparation d'un élément profilé en un matériau polymère au moins partiellement photo-durci ou thermo-durci et
- une étape de fermeture de l'élément profilé sur un couvercle de façon à délimiter au moins un microcanal,
caractérisé en ce que le procédé comprend en outre une étape de traitement de surface d'au moins une partie des parois internes dudit microcanal selon le procédé défini dans la présente invention.

Enfin, l'utilisation d'une irradiation sous oxygène à une longueur d'onde inférieure ou égale à 300 nm, de préférence de 150 à 260 nm, pour rendre au moins localement plus hydrophiles les parois d'un microcanal formé dans un matériau polymère au moins partiellement photo-durci ou thermo-durci en conservant intactes les propriétés de volume dudit matériau, est également décrite ici.

### BREVE DESCRIPTION DES FIGURES

La **figure 1** représente un mode de réalisation du procédé de traitement de surface selon l'invention.
La **figure 2** représente un autre mode de réalisation du procédé de traitement de surface selon l'invention.
La **figure 3** représente la valeur de l'angle de contact de l'eau dans l'air sur une surface de NOA®81 en fonction de la durée de l'étape de traitement de surface (irradiation à 185 et 254 nm).
La **figure 4** représente la valeur de l'angle de contact de l'eau dans l'air sur une surface de NOA®81 en fonction de la durée de l'étape de traitement de surface (irradiation à 365 nm).
La **figure 5** représente la valeur de l'angle de contact de l'eau dans l'air sur une surface de NOA®81 en fonction de la durée de vieillissement, pour deux traitements de surface de durées différentes.

### DESCRIPTION DETAILLEE

Par « dispositif microfluidique », on entend dans la présente invention un dispositif comprenant au moins un microcanal dans lequel peut s'écouler un fluide, en particulier un liquide. Un microcanal est un canal dont au moins l'une des dimensions, typiquement la hauteur et/ou la largeur, va du nanomètre au millimètre, typiquement de 1 nm à 1 mm. Le dispositif microfluidique peut en outre comprendre un ou plusieurs réservoirs, une ou plusieurs chambres de réaction, une ou plusieurs chambres de mélange et une ou plusieurs zones de séparation.

Le microcanal est délimité dans le dispositif microfluidique par ses parois internes. Dans le procédé de fabrication du dispositif microfluidique, les parois internes du microcanal peuvent être en un matériau ou en plusieurs matériaux différents. Selon l'invention, le microcanal est délimité par un élément profilé en un premier matériau et par un couvercle en un second matériau. Le premier et le second matériau peuvent être les mêmes ou différents. Selon un mode de réalisation classique, le couvercle est un élément plat. L'élément profilé a donc une forme qui lui permet, lorsqu'il est fermé par un couvercle plat, de définir un microcanal. Cependant, toute autre configuration est envisagée dans la présente invention. En particulier, il est envisagé de disposer d'un couvercle non plat, ayant par exemple lui aussi une forme profilée et ayant éventuellement des ouvertures.

Dans le procédé selon l'invention, l'élément profilé délimitant le microcanal est en un matériau polymère au moins partiellement photo-durci ou thermo-durci.

Par opposition aux polymères thermoplastiques, les polymères thermo- ou photo-durcis sont des matières plastiques pratiquement infusibles et insolubles après leur polymérisation. Avant polymérisation, le matériau, qualifié de résine thermo- ou photo-durcissable, est sous forme liquide ou pâteuse. La polymérisation (ou durcissement) de la résine est provoquée par traitement thermique dans le cas des résines thermo-durcissables ou par irradiation dans le cas des résines photo-durcissables.

Les matériaux polymères thermo- ou photo-durcis sont particulièrement bien adaptés à la réalisation de dispositifs microfluidiques. En effet, l'étape consistant à fermer, puis éventuellement à sceller, l'élément profilé sur le couvercle est plus simple à réaliser avec des matériaux polymères thermo- ou photo-durcis qu'avec des matériaux thermoplastiques. Un exemple de fabrication de dispositifs microfluidiques à partir de résines thermo- ou photo-durcissables peut être trouvé dans la demande internationale de brevet WO 2008/009803.

L'expression « au moins partiellement photo-durci ou thermo-durci » telle qu'utilisée dans la présente demande signifie que la polymérisation de la résine peut être complète ou non. Ainsi, le matériau peut être totalement sous forme polymérisée ou bien partiellement sous forme polymérisée et partiellement sous forme de résine.

Parmi les matériaux polymères au moins partiellement thermo-durcis pouvant être utilisés dans la présent invention, on peut citer le PDMS (polydiméthoxysilane), le polyuréthane et le PMMA (polyméthacrylate de méthyle).

Le matériau polymère de l'invention peut avantageusement être un matériau polymère au moins partiellement photo-durci. La polymérisation provoquée par irradiation est facile à mettre en oeuvre, peu coûteuse, permet un prototypage rapide et donne un produit doté d'une très bonne résolution. De préférence, le matériau polymère est obtenu à partir d'une résine photo-durcissable par irradiation à une longueur d'onde supérieure 300 nm, de préférence de 320 à 800 nm.

Parmi les matériaux polymères au moins partiellement photo-durcis pouvant être utilisés dans la présente invention, on peut citer les produits commercialisés par la société Norland Optics sous la marque NOA® Norland Optial Adhesives, comme en particulier des produits NOA®81 et NOA®60, les produits commercialisés par la société Dymax dans la gamme « Dymax Adhesive and light curing systems », les produits commercialisés par la société Bohle dans la gamme « UV adhesives » et les produits commercialisés par la société Sartomer sous les références commerciales SR496 et SR499.

Avantageusement, le matériau polymère au moins partiellement photo-durci ou thermo-durci de l'invention peut être un matériau habituellement utilisé comme adhésif, colle ou revêtement de surface dans le domaine de l'optique. Ces matériaux présentent l'avantage d'être transparents, dépourvus de bulles et de toute autre irrégularité. Ils sont appropriés pour l'observation et la détection optique.

Selon un mode de réalisation particulièrement avantageux, le matériau polymère au moins partiellement photo-durci ou thermo-durci de l'invention est obtenu à partir d'une résine photo-durcissable liquide contenant des mercaptoesters et réticulant par des réactions de type thiolène. Il s'agit en particulier du produit NOA®81 commercialisé par la société Norland Optics. Ce matériau présente l'avantage de bien résister à la pression et aux solvants organiques et aqueux.

Les matériaux au caractère non élastomère ou peu élastomère sont préférés pour leur capacité de résistance à la pression.

Le procédé objet de la présente invention comprend une étape consistant à irradier sous air, donc en présence d'oxygène, le matériau polymère au moins partiellement photo-durci ou thermo-durci.

L'irradiation est faite à une longueur d'onde inférieure ou égale à 300 nm. De préférence, l'irradiation est faite à une longueur d'onde allant de 150 à 260 nm. Il est possible d'irradier à une seule longueur d'onde, à plusieurs longueurs d'ondes, par exemple à deux ou trois longueurs d'ondes, ou selon un spectre continu de longueurs d'ondes.

Le matériau peut être irradié au moyen d'une lampe à ultra-violets (UV). De nombreuse lampes UV permettant de produire une lumière UV ayant la longueur d'onde désirée sont disponibles dans le commerce. La lampe UV peut être disposée de n'importe quelle manière, dans la mesure où la lumière produite vient irradier le matériau.

La puissance de l'irradiation émise par la lampe peut être comprise entre 10 et 200 mW/cm², préférentiellement entre 25 et 30 mW/cm².

L'irradiation a lieu en présence d'oxygène. L'oxygène (O₂) peut être mis en contact avec le matériau sous forme gazeuse pure ou sous forme gazeuse en mélange avec d'autres gaz. Dans la présente invention, il s'agit d'air. L'oxygène absorbe une partie de l'irradiation UV pour former de l'ozone (O₃). L'oxygène et l'ozone se dissocient sous irradiation respectivement à 184,9 nm et à 253,7 nm. Les espèces chimiques qui se forment sont particulièrement réactives et contribuent, avec l'irradiation, à la modification de la surface traitée.

La puissance de l'irradiation reçue par un matériau dépend de la puissance de l'irradiation émise par la source d'irradiation, mais aussi de la quantité d'irradiation absorbée par l'oxygène. Cette quantité dépendant elle-même de la concentration d'oxygène dans le milieu et de la distance séparant la source d'irradiation et la surface traitée. L'homme du métier sait comment ajuster ces différents paramètres de façon à obtenir la puissance d'irradiation reçue par la surface qu'il désire.

Le procédé de traitement de surface de l'invention a également pour caractéristique de conserver intactes les propriétés de volume du matériau.

Il peut être vérifié expérimentalement par l'homme du métier si les propriétés de volume du matériau ont été conservées après le traitement de surface. On considère que cette condition est réalisée si au moins une propriété de volume a été conservée.

Une propriété de volume du matériau mesurable aisément est le module élastique du matériau. Par exemple, on peut vérifier si le module élastique du matériau a été conservé soit par observation de la déformation d'un microcanal, soit par mesure du temps de réponse d'un dispositif lors de l'écoulement d'un fluide.

L'observation de la déformation d'un microcanal consiste à injecter dans ce microcanal un fluide à une pression imposée et à mesurer la largeur du microcanal. Si la largeur du microcanal est la même avant et après le traitement de surface, alors le module élastique du matériau a été conservé.

La mesure du temps de réponse d'un dispositif lors de l'écoulement d'un fluide consiste à injecter dans le microcanal un fluide avec un débit imposé, puis de couper ce débit et de mesurer le temps qui s'écoule entre la coupure du débit et l'arrêt de l'écoulement du fluide en un point précis du microcanal. La mesure peut être réalisée classiquement par la technique PIV (Vélocimétrie par Image de Particules). Si le temps de réponse du microcanal est la même avant et après le traitement de surface, alors le module élastique du matériau a été conservé.

Pour que les propriétés de volume du matériau ne soient pas altérées, l'homme du métier peut adapter le procédé de traitement de surface de manière à contrôler la profondeur du traitement. Avantageusement, la profondeur du traitement peut être de 100 nm ou moins. La profondeur du traitement peut être inférieure à 1% de l'épaisseur totale du dispositif microfluidique, avantageusement inférieure à 1 pour 1 000, et encore plus avantageusement inférieure à 1 pour 10 000. De préférence, l'étape d'irradiation dure moins de 20 minutes, de préférence de 2 à 15 minutes.

De préférence, pour obtenir une hydrophilisation maximale, les conditions opératoires sont choisies de manière à ce que les surfaces irradiées reçoivent une énergie d'irradiation comprise entre 1000 mJ/cm² et 3000 mJ/cm², plus préférentiellement entre 1500 mJ/cm² et 3000 mJ/cm², et encore plus préférentiellement entre 2000 mJ/cm² et 3000 mJ/cm². Toutefois, des énergies d'irradiation inférieures, comprises notamment entre 0 mJ/cm² et 1000 mJ/cm², plus préférentiellement entre 100 mJ/cm² et 1000 mJ/cm², peuvent être avantageusement utilisées pour moduler l'énergie de surface, et donc les propriétés de mouillage et d'adhésion des surfaces.

Le procédé objet de la présente invention comprend une étape consistant à irradier sous air
- soit ledit matériau polymère au moins partiellement photo-durci ou thermo-durci à travers le couvercle, le couvercle et l'élément profilé ayant été préalablement assemblés, le couvercle étant constitué d'un matériau transparent auxdites irradiations,
- soit directement ledit matériau polymère au moins partiellement photo-durci ou thermo-durci, les parties de l'élément profilé destinées à assurer la fermeture avec le couvercle ayant été préalablement protégées desdites irradiations.

L'irradiation peut donc être réalisée après que le couvercle et l'élément profilé aient été assemblés ou avant que le couvercle et l'élément profilé aient été assemblés.

Dans la première alternative, le couvercle est constitué d'un matériau transparent aux irradiations. Ce mode de réalisation est particulièrement avantageux car il permet de modifier la mouillabilité des parois internes d'un microcanal *in situ,* après que le microcanal a été fabriqué. De ce fait, le traitement de surface est indépendant de la fabrication du dispositif microfluidique. Le dispositif microfluidique peut donc être préparé selon les techniques déjà connues et maîtrisées. En particulier, le traitement de surface selon l'invention n'a pas d'influence sur la qualité de l'assemblage de l'élément profilé avec le couvercle.

Dans cette première alternative, le matériau polymère au moins partiellement photo-durci ou thermo-durci est irradié à travers le couvercle. Parmi les matériaux transparents aux irradiations utilisées pour l'étape de traitement de surface, on peut citer le quartz, le saphir, et certains plastiques particuliers transparents aux UV. Le couvercle peut avantageusement être une lame de quartz car le quartz, qui est transparent, est approprié à l'observation ou à la détection optique.

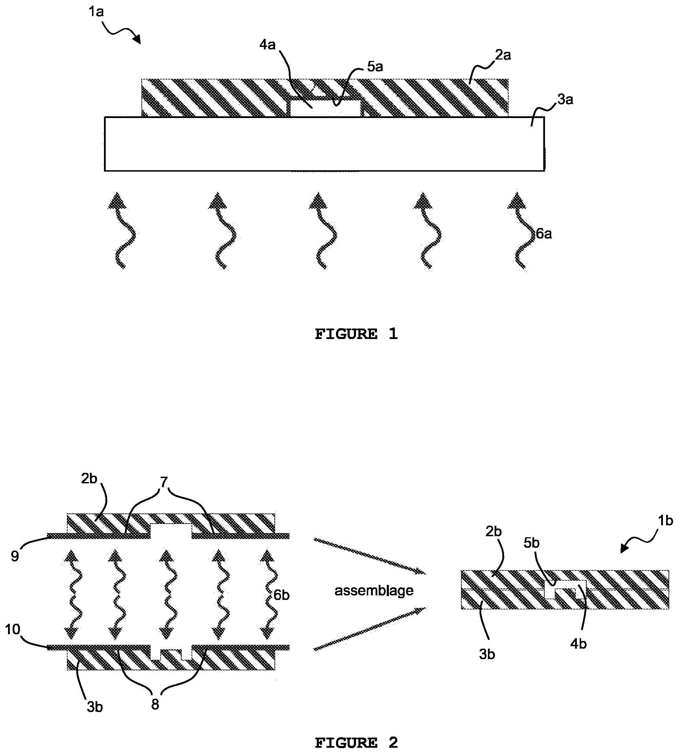

Le procédé de traitement de surface selon cette première alternative est représenté schématiquement sur la **figure 1****.**

Le dispositif microfluidique **la** comprend un élément profilé en un matériau polymère au moins partiellement photo-durci ou thermo-durci **2a** et un couvercle **3a** en quartz. L'élément profilé **2a** et le couvercle **3a** ont été assemblés et ils délimitent un microcanal **4a.**

De façon à modifier l'énergie de surface des parois internes **5a** du microcanal **4a,** le matériau polymère est irradié à travers le couvercle **3a,** les flèches **6a** représentant l'irradiation.

Dans la seconde alternative, les parties de l'élément profilé destinées à assurer la fermeture avec le couvercle sont préalablement protégées et le matériau polymère au moins partiellement photo-durci ou thermo-durci est directement irradié. Les parties de l'élément profilé destinées à assurer la fermeture avec le couvercle sont en particulier les surfaces de l'élément profilé qui vont être mises en contact avec le couvercle lors de l'assemblage.

La protection des parties de l'élément profilé peut être obtenue par masquage. Le masquage peut être réalisé puis le masquage peut être retiré selon les méthodes connues de l'homme du métier. Par exemple, un masque peut être réalisé par un dépôt métallique prenant la forme du motif voulu sur un support transparent aux irradiations UV, de préférence sur une lame de quartz. Ce masque peut alors être posé sur l'échantillon, de préférence à une distance la plus faible possible, et l'irradiation est ensuite réalisée à travers le masque, puis le masque est retiré. L'étape de masquage de certaines parties du matériau polymère permet de protéger ces parties des irradiations du traitement de surface. Les parties ainsi totalement protégées de l'irradiation ne sont pas modifiées par irradiation avant la fermeture avec le couvercle. Le procédé selon l'invention ne comprend notamment pas d'étape supplémentaire d'irradiation destinée à modifier les parties de l'élément profilé destinées à assurer la fermeture avec le couvercle avant fermeture. Ceci est avantageux car l'assemblage de l'élément profilé avec le couvercle peut ensuite être réalisé selon les techniques connues et maîtrisées, sans opération particulière par rapport à l'assemblage d'un dispositif microfluidique n'ayant pas subi le traitement de surface selon l'invention. Le traitement de surface selon l'invention n'a ainsi pas d'influence sur la qualité de l'assemblage de l'élément profilé avec le couvercle.

Dans cette seconde alternative, le couvercle peut être en n'importe quel matériau. Avantageusement, le couvercle peut être dans un matériau identique à celui de l'élément profilé. Ce procédé permet de réaliser des dispositifs microfluidiques avec un microcanal dont toutes les parois sont dans le même matériau.

En outre, il est envisagé de traiter la surface du couvercle constituant une paroi du microcanal de la même manière que l'élément profilé. De cette façon, le procédé de traitement selon l'invention est mis en oeuvre sur l'ensemble des parois du microcanal.

Le procédé de traitement de surface selon cette première alternative est représenté schématiquement sur la **figure 2****.**

Le dispositif microfluidique **1b** comprend un élément profilé en un matériau polymère au moins partiellement photo-durci ou thermo-durci **2b** et un couvercle **3b** dans le même matériau polymère au moins partiellement photo-durci ou thermo-durci. Le couvercle **3b** n'est pas plat, mais comprend des rainures. Après assemblage, l'élément profilé **2b** et le couvercle **3b** délimitent un microcanal **4b.**

Lors de l'assemblage, les surfaces **7** de l'élément profilé **2b** viennent au contact des surfaces **8** du couvercle **3b.** Les surfaces **7** et **8** ont été préalablement protégées par des masques **9** et **10.**

De façon à modifier l'énergie de l'ensemble de la surface des parois internes **5b** du microcanal **4b,** le matériau polymère de l'élément profilé **2b** est irradié, ainsi que le matériau polymère du couvercle **3b,** les flèches **6b** représentant l'irradiation. Par contre, les surfaces **7** et **8** totalement protégées par des masques **9** et **10** ne sont pas modifiées par irradiation.

Après retrait des masques **9** et **10,** l'élément profilé **2b** et le couvercle **3b** peuvent être assemblés.

Les inventeurs ont constaté que le procédé selon l'invention permettait de modifier au moins localement l'énergie de surface des parois interne du microcanal.

L'énergie de surface désigne l'énergie libre qui existe à la surface de séparation entre deux milieux. La mouillabilité d'une surface, c'est-à-dire la propriété de cette surface sur laquelle peut s'étaler un liquide, dépend de l'énergie de surface entre la surface en question, le liquide et le gaz ambiant. Lorsque ce liquide est de l'eau, on parle de caractère hydrophile ou hydrophobe de la surface. Le caractère hydrophile ou hydrophobe d'une surface peut être quantifié en mesurant l'angle de contact que forme une goutte d'eau avec la surface. Classiquement, on désigne par « hydrophile » une surface pour laquelle l'angle de contact de l'eau dans l'air est compris entre 0 et 90° et par « hydrophobe » une surface pour laquelle l'angle de contact de l'eau dans l'air est compris entre 90° et 180°.

Dans l'ensemble de la présente demande, le terme « angle de contact » désigne l'angle de contact mesuré à l'avancée, selon les techniques classiques bien connu de l'homme du métier dans ce domaine.

Les matériaux polymères thermo- ou photo-durcis, en particulier ceux utilisés dans la présente invention, ont généralement un caractère peu hydrophile, voire hydrophobe. C'est pourquoi, dans un dispositif microfluidique, les parois internes du microcanal avant traitement de surface sont naturellement peu hydrophiles, voire hydrophobes : l'angle de contact de l'eau dans l'air sur les parois du microcanal est typiquement supérieur à 80°, voire supérieur à 90°.

Le procédé objet de la présente invention permet avantageusement de modifier la mouillabilité des parois, et en particulier de rendre les parois plus hydrophiles. La différence entre la valeur de l'angle de contact de l'eau dans l'air sur les parois du microcanal avant traitement et la valeur de l'angle de contact de l'eau dans l'air sur les parois du microcanal après traitement est avantageusement compris entre 40 et 90°, plus avantageusement compris entre 50 et 80°, et encore plus avantageusement compris entre 60 et 70°. Ainsi, après le traitement de surface, l'angle de contact de l'eau dans l'air sur les parois du microcanal peut avantageusement être inférieur à 20°, voire inférieur à 15°, et préférentiellement compris entre 0 et 10°.

Les inventeurs ont découvert que la valeur de l'angle de contact de l'eau dans l'air sur les parois du microcanal après traitement dépend de la quantité d'irradiation reçue par la surface. Pour un dispositif donné, avec une puissance d'irradiation donnée, la valeur de l'angle de contact de l'eau dans l'air sur les parois du microcanal après traitement dépend de la durée de l'étape d'irradiation. Plus l'étape d'irradiation est longue, plus la surface obtenue est hydrophile. Le procédé selon l'invention permet ainsi de contrôler de manière simple et précise la mouillabilité des surfaces traitées.

En outre, les inventeurs ont constaté que la mouillabilité de la surface traitée est stable dans le temps. Ainsi, la différence entre la valeur de l'angle de contact de l'eau dans l'air sur les parois du microcanal juste après traitement et la valeur de l'angle de contact de l'eau dans l'air sur les parois du microcanal après 10 jours, et de préférence après 25 jours, de conservation à l'air ambiant est avantageusement compris entre 0 et 20°, plus avantageusement compris entre 0 et 15°, et encore plus avantageusement compris entre 0 et 10°. Le dispositif microfluidique traité selon l'invention peut donc être conservé avantageusement pendant 10 jours, et plus avantageusement pendant 25 jours, sans précautions spécifiques, avant d'être utilisé.

Enfin, le procédé de traitement selon l'invention présente l'avantage de pouvoir être mis en oeuvre localement. Il est donc possible grâce au procédé de traitement selon l'invention de texturer les parois des microcanaux.

Selon un mode de réalisation préféré de la présente invention, le matériau polymère au moins partiellement photo-durci ou thermo-durci est irradié localement, de préférence selon un motif.

Le traitement de surface selon l'invention peut n'être appliqué que sur certaines zones du matériau polymère, par exemple grâce à un masquage des zones où l'on ne souhaite pas appliquer le traitement. Les zones préalablement masquées conservent leur énergie de surface initiale.

Alternativement ou en plus, le traitement de surface selon l'invention peut être appliqué de façon différente sur différentes zones du matériau polymère. Il est possible en particulier de soumettre des zones du matériau polymère à différentes quantité d'irradiation. La modification de l'énergie de surface dépendant de la quantité d'irradiation reçue, on peut ainsi modifier l'énergie de surface du matériau polymère de façon différente sur des zones différentes.

Le dispositif microfluidique obtenu après le traitement selon l'invention peut avoir des zones ayant des mouillabilités différentes, la différence entre l'angle de contact de l'eau dans l'air sur deux zones du même dispositif microfluidique pouvant être supérieure à 60°, préférentiellement supérieure à 80°, et plus préférentiellement comprise entre 90 et 115°.

Le motif de l'irradiation peut être m'importe quel motif désiré par l'homme du métier.

Dans un premier exemple, le microcanal peut être divisé dans le sens de la longueur en deux bandes égales et symétriques par rapport à un plan médian du microcanal. Une des bandes peut être traitée par le procédé selon l'invention, tandis que l'autre bande est cachée par un masquage. Lorsque le masquage est enlevé, on obtient un microcanal texturé avec une partie du microcanal qui a un caractère plus hydrophile que l'autre.

Dans un deuxième exemple, le microcanal peut être traité de façon à avoir une mouillabilité décroissante dans le sens de sa longueur. Pour ce faire, on peut utiliser un masquage mobile : celui-ci est initialement disposé de façon à cacher la quasi-totalité du microcanal, puis le masquage mobile est retiré progressivement, selon l'axe longitudinal du canal, durant le traitement selon l'invention. Les zones irradiées le plus longtemps ont leur énergie de surface le plus modifiée tandis que les zones irradiées le moins longtemps ont leur énergie de surface le moins modifiée. Le déplacement du masquage peut être fait par palier, permettant d'obtenir une mouillabilité décroissante par palier, ou le déplacement du masquage peut être fait de façon continue, permettant d'obtenir une mouillabilité avec une décroissance continue dans l'espace.

La présente invention a en outre pour objet un procédé de fabrication d'un dispositif microfluidique, comprenant :
- une étape de préparation d'un élément profilé en un matériau polymère au moins partiellement photo-durci ou thermo-durci et
- une étape de fermeture de l'élément profilé sur un couvercle de façon à délimiter au moins un microcanal,
caractérisé en ce que le procédé comprend en outre une étape de traitement de surface d'au moins une partie des parois internes dudit microcanal selon le procédé défini ci-avant.

L'étape de préparation d'un élément profilé en un matériau polymère au moins partiellement photo-durci ou thermo-durci et l'étape de fermeture de l'élément profilé sur un couvercle de façon à former au moins un microcanal peuvent être réalisées selon la méthode décrite dans la demande internationale de brevet WO 2008/009803.

Spécifiquement, l'étape de préparation d'un élément profilé peut comprendre l'utilisation d'un timbre en un matériau élastomérique pour imprimer une résine photo- ou thermo-durcissable placée que un support, puis une étape d'irradiation ou de chauffage pour former l'élément profilé.

Ce mode de réalisation est particulièrement avantageux car l'utilisation du timbre en un matériau élastomérique permet d'éviter la polymérisation totale de l'élément profilé. L'interface entre l'élément profilé et le timbre conserve un film de résine non durcie. La présence de ce film permet ensuite de fermer l'élément profilé sur un couvercle, et de sceller cette fermeture, par exemple par une simple irradiation.

Le procédé selon l'invention est avantageux dans la mesure où l'étape de fermeture de l'élément profilé avec le couvercle peut être réalisée selon les techniques connues et maîtrisées, sans nécessiter un traitement spécifique, malgré le traitement de surface d'au moins une partie des parois internes du microcanal. L'étape de fermeture de l'élément profilé sur un couvercle peut être réalisée par exemple par collage thermique ou chimique. Dans un mode de réalisation particulièrement préféré, l'étape de fermeture de l'élément profilé sur un couvercle est réalisée par pression, éventuellement suivie d'une étape de scellage, par exemple par irradiation à une longueur d'onde correspondant à la longueur d'onde de durcissement du matériau polymère, ou par chauffage. Le couvercle peut être dans un matériau identique ou distinct de celui de l'élément profilé.

L'étape de traitement de surface d'au moins une partie des parois internes du microcanal qui est alors obtenu peut être réalisée avant l'étape de fermeture ou après l'étape de fermeture du microcanal.

Selon un premier mode de réalisation, l'étape de traitement de surface est effectuée après l'étape de fermeture, le couvercle étant constitué d'un matériau transparent aux irradiations utilisées pour l'étape de traitement de surface. Ce mode de réalisation est particulièrement avantageux car il permet de modifier la mouillabilité des parois internes d'un microcanal *in situ,* après que le microcanal a été fabriqué. De ce fait, l'étape de fermeture du microcanal et l'étape de traitement de surface de celui-ci sont indépendantes l'une de l'autre. L'étape de traitement de surface ne gène pas l'étape de fermeture. Inversement, l'étape de fermeture n'empêche pas l'étape de traitement de surface.

Selon ce premier mode de réalisation, le traitement de surface d'au moins une partie des parois internes du microcanal est réalisé selon le procédé décrit ci-avant en irradiant des parois internes du microcanal à travers le couvercle. Parmi les matériaux transparents aux irradiations utilisées pour l'étape de traitement de surface, on peut citer le quartz, le saphir, et certains plastiques particuliers transparents aux UV. Le couvercle peut avantageusement être une lame de quartz car le quartz, qui est transparent, est approprié à l'observation ou à la détection optique.

Selon un second mode de réalisation, l'étape de traitement de surface est effectuée avant l'étape de fermeture, les parties de l'élément profilé assurant la fermeture avec le couvercle étant protégées lors du traitement de surface des irradiations utilisées pour l'étape de traitement de surface. Les parties de l'élément profilé assurant la fermeture avec le couvercle ne sont pas modifiées par irradiation car elles sont totalement protégées.

Le procédé de fabrication d'un dispositif microfluidique peut alors comprendre les étapes consécutives suivantes :
- l'étape de préparation d'un élément profilé en un matériau polymère au moins partiellement photo-durci ou thermo-durci,
- une étape de masquage de certaines parties du matériau polymère,
- l'étape de traitement de surface d'au moins une partie du matériau polymère, telle que décrite ci-avant,
- une étape de retrait du masquage, et
- l'étape de fermeture de l'élément profilé sur un couvercle de façon à former au moins un microcanal, les parties du matériau polymère ayant été masquées étant les parties en contact avec le couvercle.

Avantageusement, le procédé selon l'invention ne comprend pas d'étape intermédiaire entre l'étape de retrait du masquage et l'étape de fermeture. Le procédé peut notamment ne pas comprendre d'étape supplémentaire d'irradiation destinée à modifier les parties de l'élément profilé destinées à assurer la fermeture avec le couvercle avant fermeture.

Le masquage peut être réalisé puis le masquage peut être retiré selon les méthodes connues de l'homme du métier, par exemple par la réalisation d'un dépôt métallique de prenant la forme du motif voulu sur un support transparent aux irradiations UV, de préférence sur une lame de quartz. Ce masque peut alors être posé sur l'échantillon, de préférence à une distance la plus faible possible, et l'irradiation est ensuite réalisée à travers le masque, puis le masque est retiré. L'étape de masquage de certaines parties du matériau polymère permet de protéger ces parties des irradiations du traitement de surface. Ainsi, on conserve le film de résine non durcie sur certaines parties de l'élément profilé. Ce film permet ensuite de fermer l'élément profilé sur le couvercle.

Selon ce second mode de réalisation, le couvercle peut être en n'importe quel matériau. Avantageusement, le couvercle peut être dans un matériau identique à celui de l'élément profilé. Ce procédé permet de réaliser des dispositifs microfluidiques avec un microcanal dont toutes les parois sont dans le même matériau.

En outre, il est envisagé de traiter la surface du couvercle constituant une paroi du microcanal de la même manière que l'élément profilé.

Le procédé de fabrication d'un dispositif microfluidique peut alors comprendre, outre les étapes de préparation et de traitement de surface de l'élément profilé, les étapes consécutives suivantes :
- une étape de préparation du couvercle en un matériau polymère au moins partiellement photo-durci ou thermo-durci,
- une étape de masquage de certaines parties du matériau polymère du couvercle,
- une étape de traitement de surface d'au moins une partie du couvercle, telle que décrite ci-avant,
- une étape de retrait du masquage, et
- l'étape de fermeture de l'élément profilé sur le couvercle de façon à former au moins un microcanal, les parties du matériau polymère du couvercle ayant été masquées étant les parties qui sont mises en contact avec l'élément profilé.

Ce mode de réalisation permet de fabriquer un dispositif microfluidique avec un microcanal dont toutes les parois sont dans le même matériau et dont toutes les parois ont été traitées de la même manière par le procédé de traitement de surface selon l'invention.

Enfin, l'utilisation d'une irradiation sous oxygène à une longueur d'onde inférieure ou égale à 300 nm, de préférence de 150 à 260 nm, pour rendre au moins localement plus hydrophiles les parois d'un microcanal formé dans un matériau polymère au moins partiellement photo-durci ou thermo-durci en conservant intactes les propriétés de volume dudit matériau est décrite ici. La différence entre la valeur de l'angle de contact de l'eau dans l'air sur les parois du microcanal avant traitement et la valeur de l'angle de contact de l'eau dans l'air sur les parois du microcanal après traitement est avantageusement compris entre 40 et 90°, plus avantageusement compris entre 50 et 80°, et encore plus avantageusement compris entre 40 et 70°.

D'autres caractéristiques et avantages de l'invention apparaîtront de l'exemple décrit ci-dessous.

### EXEMPLES

Des lames de NOA®81 ont été préparées selon le protocole ci-dessous :
Sur une lame de verre, on a écrasé quelques millilitres de NOA®81, à l'aide d'un tampon avec une surface plane de PDMS préalablement mise sous vide pendant au moins 30 minutes. On a laissé le système ainsi pendant 10 minutes afin d'enlever les bulles d'airs piégées. On a exposé ensuite l'ensemble sous une lampe UV pendant 7 secondes à une puissance de 12 mW/cm² de façon à provoquer le durcissement de la résine. On a retiré alors le tampon pour obtenir une lame de verre couverte d'une couche de NOA®81.

La couche de NOA®81 avait à sa surface une pellicule de résine non durcie. Pour les besoins des tests, la résine a été totalement durcie. Pour ce faire, on a remis lame de verre sous la lampe UV pendant 1 minute à 40 mW/cm².

Une partie des lames a été traitée selon le procédé objet de la présente invention :
Les lames ont été disposées sous une lampe UV ayant deux pics d'émissions à 185 et 254 nm. La distance entre la lampe et la lame était constante et d'environ 3 cm. L'atmosphère autours des lames était de l'air.

On a fait varié la durée de l'irradiation entre 0 seconde et 15 minutes.

Une autre partie des lames a été traitée de la même manière, sauf que l'irradiation a été faite à une longueur d'onde de 365 nm.

La mouillabilité des surfaces a été évaluée en mesurant l'angle de contact de gouttes d'eau dans l'air sur les lames de NOA®81 non traitées en surface et sur les lames de NOA®81 traitées en surface avec différents temps d'exposition.

La mesure de l'angle de contact a été effectuée à l'aide d'un appareil de mesure DSA30 de la société KRUSS. Sur chaque lame, une goutte d'eau a été déposée puis gonflée pour mesurer l'angle de contact à l'avancé. La lecture de l'angle est effectuée à l'aide du logiciel fourni avec l'appareil.

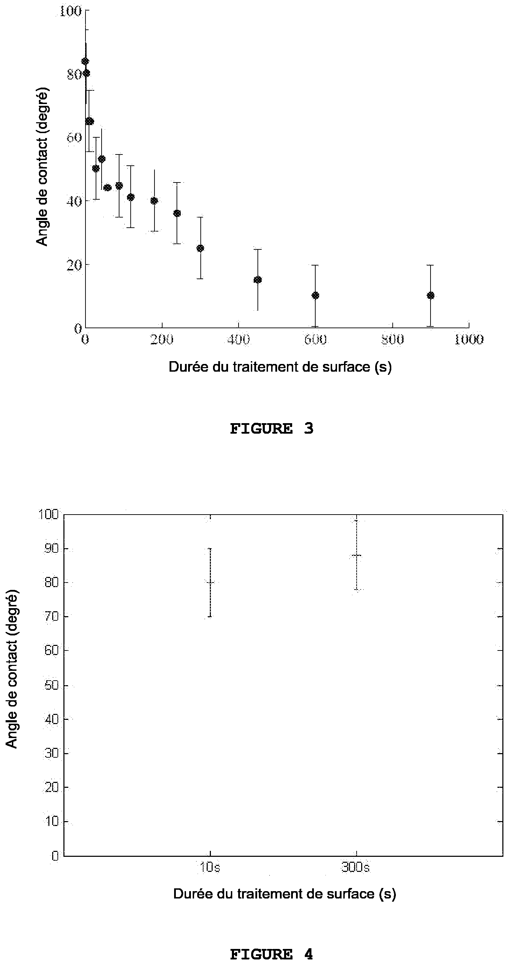

La **figure 3** présente les résultats des mesures d'angles de contact sur les surfaces traitées.

La surface de NOA®81 non traitée a un angle de contact d'environ 80°. On constate que la valeur de l'angle de contact de l'eau dans l'air sur la surface du polymère après traitement dépend de la durée de l'étape d'irradiation. Ici, l'angle de contact décroît jusqu'à une valeur d'environ 10°.

La **figure 4** présente les résultats des mesures d'angles de contact sur les surfaces traitées par irradiation à une longueur d'onde de 365 nm. On constate que ce traitement n'a pas d'effet sur l'angle de contact.

La stabilité du caractère hydrophile de la surface après traitement a été évaluée en laissant vieillir pendant 25 jours plusieurs lames traitées selon le procédé décrit ci-dessus avec une irradiation à 185 et 254 nm pendant 120 et 600 secondes. Les lames ont été laissées à l'air libre, à l'intérieur d'une boîte de Pétri pour les protéger de la poussière et d'éventuels contacts.

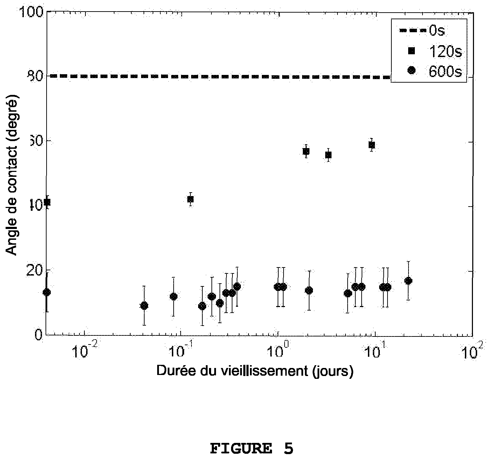

La **figure 5** présente les résultats des mesures d'angles de contact, en fonction de la durée de vieillissement, pour deux temps d'irradiation. La ligne en pointillé correspond à la valeur de l'angle de contact sur une surface non traitée.

On constate que les valeurs d'angles de contact varient peu sur une durée d'environ dix jours. Pour la surface traitée pendant 600 secondes, l'angle de contact a varié d'environ 10° au bout de 10 jours. Pour la surface traitée pendant 120 secondes, l'angle de contact a varié d'environ 20° au bout de 10 jours.

En outre, on constate que malgré ses petites variations, l'angle de contact n'augment pas jusqu'à la valeur d'un angle de contact mesuré sur une surface non traitée. Le traitement de surface selon l'invention produit bien un effet durable dans le temps.

## Revendications

1. Procédé de traitement de surface des parois internes d'un microcanal, dans un dispositif microfluidique, destiné à modifier au moins localement l'énergie de surface desdites parois, le microcanal étant délimité par un élément profilé en un matériau polymère au moins partiellement photo-durci ou thermo-durci et par un couvercle, comprenant une étape consistant à irradier sous air,
- soit ledit matériau polymère au moins partiellement photo-durci ou thermo-durci à travers le couvercle, le couvercle et l'élément profilé ayant été préalablement assemblés, le couvercle étant constitué d'un matériau transparent auxdites irradiations,
- soit directement ledit matériau polymère au moins partiellement photo-durci ou thermo-durci, les parties de l'élément profilé destinées à assurer la fermeture avec le couvercle ayant été préalablement protégées desdites irradiations de manière à ce que lesdites parties ne soient pas modifiées par irradiation avant la fermeture avec le couvercle,
l'irradiation étant faite à une longueur d'onde inférieure ou égale à 300 nm, et la profondeur d'irradiation est contrôlée de manière à conserver intactes les propriétés de volume du matériau, la profondeur de traitement étant inférieure ou égale à 100 nm ou étant inférieure à 1% de l'épaisseur totale du dispositif microfluidique.

2. Procédé selon la revendication 1, **caractérisé par le fait que** l'irradiation est faite à une longueur d'onde allant de 150 à 260 nm.

3. Procédé selon l'une quelconque des revendications 1 à 2, **caractérisé par le fait que** l'étape d'irradiation dure moins de 20 minutes, de préférence de 2 à 15 minutes.

4. Procédé selon l'une quelconque des revendications 1 à 3, **caractérisé par le fait que** le matériau polymère est un matériau polymère au moins partiellement photo-durci.

5. Procédé selon la revendication 4, **caractérisé par le fait que** le matériau polymère est obtenu à partir d'une résine photo-durcissable par irradiation à une longueur d'onde supérieure à 300 nm, de préférence de 320 à 800 nm.

6. Procédé selon l'une quelconque des revendications 1 à 5, **caractérisé par le fait que** ledit matériau polymère au moins partiellement photo-durci ou thermo-durci n'est irradié que localement, de préférence selon un motif.

7. Procédé de fabrication d'un dispositif microfluidique, comprenant :
- une étape de préparation d'un élément profilé en un matériau polymère au moins partiellement photo-durci ou thermo-durci et
- une étape de fermeture de l'élément profilé sur un couvercle de façon à délimiter au moins un microcanal, **caractérisé en ce que** le procédé comprend en outre une étape de traitement de surface d'au moins une partie des parois internes dudit microcanal selon le procédé défini selon l'une quelconque des revendications 1 à 6.

8. Procédé selon la revendication 7, **caractérisé par le fait que** l'étape de traitement de surface est effectuée après l'étape de fermeture, le couvercle étant constitué d'un matériau transparent aux irradiations utilisées pour l'étape de traitement de surface.

9. Procédé selon la revendication 7, **caractérisé par le fait que** l'étape de traitement de surface est effectuée avant l'étape de fermeture, les parties de l'élément profilé assurant la fermeture avec le couvercle étant protégées lors du traitement de surface des irradiations utilisées pour l'étape de traitement de surface.

10. Procédé selon la revendication 9, comprenant les étapes consécutives suivantes :
- l'étape de préparation d'un élément profilé en un matériau polymère au moins partiellement photo-durci ou thermo-durci,
- une étape de masquage de certaines parties du matériau polymère,
- l'étape de traitement de surface d'au moins une partie du matériau polymère, selon le procédé défini selon l'une quelconque des revendications 1 à 6,
- une étape de retrait du masquage, et
- l'étape de fermeture de l'élément profilé sur un couvercle de façon à former au moins un microcanal, les parties du matériau polymère ayant été masquées étant les parties en contact avec le couvercle.

## Patentansprüche

1. Verfahren zur Oberflächenbehandlung der Innenwände eines Mikrokanals in einer mikrofluidischen Vorrichtung, um die Oberflächenenergie dieser Wände zumindest lokal zu modifizieren, wobei der Mikrokanal durch ein Profilelement aus einem mindestens teilweise photogehärteten oder thermisch gehärteten Polymermaterial und durch einen Deckel begrenzt ist, umfassend einen Schritt bestehend aus Bestrahlen unter Luft,
- entweder des mindestens teilweise photogehärteten oder thermisch gehärteten Polymermaterials durch den Deckel, wobei der Deckel und das Profilelement zuvor zusammengefügt worden sind, wobei der Deckel aus einem für die Bestrahlungen transparenten Material gebildet ist,
- oder direkt des mindestens teilweise photogehärteten oder thermisch gehärteten Polymermaterials, wobei die Teile des Profilelements, die einen Verschluss mit dem Deckel gewährleisten sollen, zuvor vor den Bestrahlungen in einer Weise geschützt worden sind, dass die Teile vor dem Verschluss mit dem Deckel nicht durch Bestrahlung modifiziert werden,
wobei die Bestrahlung bei einer Wellenlänge von weniger als oder gleich 300 nm durchgeführt wird und die Tiefe der Bestrahlung so kontrolliert wird, dass die Volumeneigenschaften des Materials unberührt bewahrt werden, wobei die Tiefe der Behandlung weniger als oder gleich 100 nm beträgt oder weniger als 1% der Gesamtdicke der mikrofluidischen Vorrichtung beträgt.

2. Verfahren nach Anspruch 1, **dadurch gekennzeichnet, dass** die Bestrahlung bei einer Wellenlänge von 150 bis 260 nm durchgeführt wird.

3. Verfahren nach einem der Ansprüche 1 bis 2, **dadurch gekennzeichnet, dass** der Bestrahlungsschritt weniger als 20 Minuten, vorzugsweise 2 bis 15 Minuten dauert.

4. Verfahren nach einem der Ansprüche 1 bis 3, **dadurch gekennzeichnet, dass** das Polymermaterial ein zumindest teilweise photogehärtetes Polymermaterial ist.

5. Verfahren nach Anspruch 4, **dadurch gekennzeichnet, dass** das Polymermaterial aus einem photohärtbaren Harz durch Bestrahlung bei einer Wellenlänge oberhalb von 300 nm, vorzugsweise von 320 bis 800 nm, erhalten wird.

6. Verfahren nach einem der Ansprüche 1 bis 5, **dadurch gekennzeichnet, dass** das zumindest teilweise photogehärtete oder thermisch gehärtete Polymermaterial nur lokal bestrahlt wird, vorzugsweise nach einem Muster.

7. Verfahren zur Herstellung einer mikrofluidischen Vorrichtung, umfassend:
- einen Schritt eines Herstellens eines Profilelements aus einem mindestens teilweise photogehärteten oder thermisch gehärteten Polymermaterial und
- einen Schritt eines Verschließens des Profilelements auf einem Deckel, in einer Weise um mindestens einen Mikrokanal zu begrenzen,
**dadurch gekennzeichnet, dass** das Verfahren ferner einen Schritt einer Oberflächenbehandlung von mindestens einem Teil der Innenwände des Mikrokanals gemäß dem Verfahren nach einem der Ansprüche 1 bis 6 umfasst.

8. Verfahren nach Anspruch 7, **dadurch gekennzeichnet, dass** der Schritt einer Oberflächenbehandlung nach dem Schritt eines Verschließens durchgeführt wird, wobei der Deckel aus einem Material besteht, das für Bestrahlungen transparent ist, die für den Schritt einer Oberflächenbehandlung verwendet werden.

9. Verfahren nach Anspruch 7, **dadurch gekennzeichnet, dass** der Schritt einer Oberflächenbehandlung vor dem Schritt eines Schließens durchgeführt wird, wobei die Teile des Profilelements, die das Verschließen mit dem Deckel gewährleisten, während der Oberflächenbehandlung vor den für den Schritt einer Oberflächenbehandlung verwendeten Bestrahlungen geschützt sind.

10. Verfahren nach Anspruch 9, umfassend die folgenden aufeinander folgenden Schritte:
- den Schritt eines Herstellens eines Profilelements aus einem mindestens teilweise photogehärteten oder thermisch gehärteten Polymermaterial,
- den Schritt einer Maskierung bestimmter Teile des Polymermaterials,
- den Schritt einer Oberflächenbehandlung von mindestens einem Teil des Polymermaterials gemäß dem Verfahren nach einem der Ansprüche 1 bis 6,
- den Schritt eines Entfernens der Maskierung und
- den Schritt eines Verschließens des Profilelements auf einem Deckel in einer Weise, um mindestens einen Mikrokanal zu bilden, wobei die Teile des Polymermaterials, die maskiert worden sind, die mit dem Deckel in Kontakt stehenden Teile sind.

## Claims

1. A process for treating a surface of the internal walls of a microchannel, in a microfluidic device, intended to modify at least locally a surface energy of said walls, the microchannel being bounded by a profiled element made of an at least partially photo-set or thermo-set polymer and by a cover, said process comprising a step of irradiating under air,
- either said at least partially photo-set or thermo-set polymer through the cover, the cover and the profiled element having been assembled beforehand, the cover being made of a material that is transparent to said irradiations;
- or directly said at least partially photo-set or thermo-set polymer, those portions of the profiled element which are intended to ensure a joint with the cover having been protected beforehand from irradiations so that said portions are not modified by irradiation before joining with the cover, the irradiation being carried out at a wavelength shorter than or equal to 300 nm, and the depth of irradiation is controlled so that the bulk properties of the material are preserved intact, the depth of the treatment being 100 mm or less or being smaller than 1% of the total thickness of the microfluidic device.

2. The process as claimed in claim 1, **characterized in that** the irradiation is carried out at a wavelength ranging from 150 to 260 nm.

3. The process as claimed in either one of claims 1 and 2, **characterized in that** the irradiation step lasts less than 20 minutes, preferably from 2 to 15 minutes.

4. The process as claimed in any one of claims 1 to 3, **characterized in that** the polymer is an at least partially photo-set polymer.

5. The process as claimed in claim 4, **characterized in that** the polymer is obtained from a photo-setting resin by irradiation at a wavelength longer than 300 nm, preferably from 320 to 800 nm.

6. The process as claimed in any one of claims 1 to 5, **characterized in that** said at least partially photo-set or thermo-set polymer is irradiated only locally, preferably with a pattern.

7. A process for manufacturing a microfluidic device, comprising:
- a step of preparing a profiled element made of an at least partially photo-set or thermo-set polymer; and
- a step of closing the profiled element with a cover so as to bound at least one microchannel,
**characterized in that** the process furthermore comprises a step of treating the surface of at least one portion of the internal walls of said microchannel with the process defined in any one of claims 1 to 6.

8. The process as claimed in claim 7, **characterized in that** the surface treatment step is carried out after the sealing step, the cover being made of a material that is transparent to the irradiations used in the surface treatment step.

9. The process as claimed in claim 7, **characterized in that** the surface treatment step is carried out before the closing step, the portions of the profiled element ensuring the joint with the cover being protected during the surface treatment from the irradiations used in the surface treatment step.

10. The process as claimed in claim 9, comprising the following consecutive steps:
- the step of preparing a profiled element made of an at least partially photo-set or thermo-set polymer;
- a step of masking certain portions of the polymer;
- the step of treating the surface of at least one portion of the polymer, with the process defined in any one of claims 1 to 6;
- a step of removing the mask; and
- the step of closing the profiled element with a cover so as to form at least one microchannel, the portions of the polymer that were masked being the portions making contact with the cover.
